# DEMANDE DE BREVET EUROPEEN

(11) **EP 3 506 326 A2**
(43) Date de publication de la demande: **03.07.2019**
(21) Numéro de dépôt: 18315056.4
(22) Date de dépôt: 28.12.2018
(51) Int. Cl.: H01F 17/04, H03H 1/00, H01F 3/04, H01F 3/10, H01F 3/14, H01F 27/25, H01F 27/26

(54) **DISPOSITIF DE FILTRAGE INDUCTIF A NOYAU MAGNETIQUE TORIQUE**

(30) Priorité: 28.12.2017 FR 1701401
(71) Demandeur: Thales, 92400 Courbevoie (FR)
(72) Inventeur: Dubois, Eric, 78400 Chatou (FR); Kherbouchi, Hocine, 78400 Chatou (FR); Lalevee, Didier, 78400 Chatou (FR)
(74) Mandataire: Collet, Alain

(57) **Abrégé**

L'invention concerne un dispositif de filtrage de type inductif comprenant :
• un premier noyau magnétique (11) torique sans entrefer formé autour d'un évidement central (12),
• un premier conducteur électrique (15) formé de spires enroulées autour du premier noyau magnétique (11) sans traverser l'évidement central (12),

dans lequel aucun conducteur électrique ne traverse l'évidement central (12).

## Description

L'invention concerne un dispositif de filtrage de type inductif. Ce type de filtrage est communément utilisé afin de réduire d'éventuelles perturbations présentes sur un conducteur électrique. Le dispositif est alors placé en série sur la ligne.

Des dispositifs de filtrage peuvent être mis en oeuvre pour un conducteur électrique isolé ou pour des conducteurs couplés. Pour les conducteurs couplés, des perturbations de mode commun ou des perturbations différentielles peuvent survenir et des montages connus de filtrages inductifs permettent d'atténuer ces deux types de perturbation.

Les dispositifs de filtrage inductifs sont généralement réalisés au moyen de conducteurs électriques enroulés. Afin d'augmenter la valeur d'inductance du dispositif, l'enroulement peut être réalisé autour d'un noyau magnétique, par exemple réalisé en matériau ferromagnétique doux, c'est-à-dire possédant un champ coercitif faible, typiquement inférieur à 1000A.m⁻¹ afin de limiter les pertes magnétique lors de leur utilisation.

Parmi les matériaux ferromagnétiques connus, il est courant de mettre en oeuvre des matériaux formés d'alliages contenant majoritairement de fer et de nickel. Ces matériaux sont apparus au début du XX^{ième} siècle et sont notamment connus sous le nom de « Permalloy » et de « Mu-métal ». Ces matériaux sont cristallins et pour atteindre de bonnes propriétés magnétiques, des traitements thermiques sont nécessaires, traitement tendant à augmenter les dimensions des grains cristallins. Cette augmentation de taille de grains tend à détériorer les propriétés mécaniques de ces alliages les rendant difficiles à mettre en forme.

Des matériaux amorphes ont ensuite été développés afin de faciliter la mise en oeuvre des matériaux ferromagnétiques. Cependant, la présence d'éléments amorphisants, tel que le bore par exemple, tend à limiter l'induction à saturation. De plus, des pertes magnétiques importantes apparaissent lors d'utilisations à haute fréquence.

Vers la fin du XX^{ième} siècle, une nouvelle famille de matériaux nanocristallins a été développée, notamment par la société Arcelor-Mittal Imphy et connue sous le nom « Finemet ». Différentes nuances sont produites sous l'appellation « Nanophy ». Elles possèdent notamment des compositions de type FeCuMSiB où M est un métal de transition. Une composition largement utilisée est du type: *Fe*_{73.5}*Cu*₁*Nb*₃*SiₓB*_{22.5-*x*} et contiennent 13.5% ou 16.5% de silicium.

Dans cette famille, des cristaux de fer-silicium sont noyés dans une matrice résiduelle amorphe. Les cristaux ont des dimensions de l'ordre du nanomètre. Par rapport aux alliages fer-nickel, les matériaux nanocristallins présentent l'avantage d'avoir une induction à saturation beaucoup plus élevée, de l'ordre de 1,3T au lieu de 0,7T typiquement pour le Permalloy.

Plus récemment, d'autres matériaux nanocristallins de type FeMB ont également été développés. Ils contiennent généralement plus de 80% de fer, 7% de métal de transition et le complément en bore. Les matériaux de cette famille comprennent des nano cristaux de fer pur. Leur induction à saturation est comparable à celle de la famille Finemet.

Les matériaux nanocristallins permettent de bénéficier de certains avantages des matériaux amorphes, notamment leur homogénéité. Ceci est du, pour les matériaux nanocristallins, à une structure composée de très petits cristaux orientés aléatoirement et répartis de manière homogène dans une matrice amorphe et donc sans joint de grains.

Les matériaux nanocristallins sont souvent réalisés sous forme de rubans que l'on enroule pour former des tores. Il est ensuite possible de mettre en oeuvre ces tores pour réaliser des inductances ou des transformateurs. Le bobinage des enroulements se fait en traversant l'évidement situé au centre du tore ce qui n'est pas aisé à réaliser Par la suite, cet évidement est appelé évidement central.

Par ailleurs, il est courant de bobiner des enroulements hors de leur circuit magnétique, ou autour d'un circuit magnétique ouvert, ce qui est beaucoup plus aisé à réaliser. Après assemblage du circuit magnétique et de l'enroulement si ce dernier est réalisé séparément, il est possible de fermer le circuit magnétique. Cependant les matériaux nanocristallins sont difficilement usinables et sont donc inadaptés à la réalisation d'un circuit magnétique ouvert.

L'invention vise à permettre une plus grande souplesse dans la mise en oeuvre de noyaux magnétiques réalisés sous forme de tore. Dans l'invention il est notamment possible d'utiliser des bobines réalisées hors d'un circuit magnétique avec un noyau magnétique torique sans entrefer.

A cet effet, l'invention a pour objet un dispositif de filtrage comprenant :
- un premier noyau magnétique torique sans entrefer de forme cylindrique s'enroulant autour d'un axe du premier noyau et formé autour d'un évidement central s'étendant également selon l'axe du premier noyau,
- un premier conducteur électrique formé de spires enroulées autour du premier noyau magnétique sans traverser l'évidement central, le premier conducteur électrique étant enroulé autour du premier noyau magnétique selon un axe d'enroulement sensiblement perpendiculaire à l'axe du premier noyau,
dans lequel aucun conducteur électrique ne traverse l'évidement central.

Alternativement, le premier conducteur électrique peut être enroulé autour du premier noyau magnétique selon un axe d'enroulement sensiblement confondu avec l'axe du premier noyau.

Par la suite, on entendra par noyau magnétique torique, toute forme de circuit magnétique fermé autour d'un évidement appelé évidement central. Toute forme de circuit magnétique fermé sans entrefer est considérée comme torique et peut être mise en oeuvre dans le cadre de l'invention. La forme du circuit magnétique autour de son évidement central peut avoir une forme de courbe, une forme polygonale ou toute forme combinée. La forme générale du circuit magnétique autour de son évidement central peut être plane voire gauche.

Avantageusement, une dimension caractéristique d'une bobine réalisée en enroulant le premier conducteur électrique est supérieure à une plus grande dimension d'une section cylindrique de l'évidement central, la dimension caractéristique et la plus grande dimension de la section cylindrique étant portées par une même direction.

De préférence, la dimension caractéristique de la bobine est sensiblement égale à une plus grande dimension extérieure du noyau magnétique portée par la direction.

Avantageusement, le dispositif comprend en outre un deuxième noyau magnétique torique formé autour d'un deuxième évidement central, le premier noyau magnétique étant disposé à l'intérieur du deuxième évidement central, de sorte que le deuxième noyau magnétique torique referme un circuit magnétique formé par le premier noyau magnétique. Le premier conducteur électrique peut être enroulé autour du premier noyau magnétique selon un axe d'enroulement sensiblement perpendiculaire à l'axe du premier noyau ou sensiblement confondu avec l'axe du premier noyau.

Un entrefer peut être présent entre le premier noyau magnétique et le deuxième noyau magnétique. Le dispositif comprend alors avantageusement au moins une cale magnétique ou amagnétique disposée dans l'entrefer.

Avantageusement, le dispositif comprend en outre un deuxième conducteur électrique formé de spires enroulées autour du deuxième noyau magnétique.

Avantageusement, aucun conducteur électrique ne traverse le deuxième évidement central, les spires du deuxième conducteur électrique étant enroulées autour du deuxième noyau magnétique sans traverser le deuxième évidement central.

Le premier noyau magnétique torique s'enroule autour d'un premier axe. Le premier conducteur électrique est enroulé autour du premier axe. Le deuxième noyau magnétique torique s'enroule autour d'un deuxième axe le premier et le deuxième axes sont avantageusement sensiblement perpendiculaires ou parallèles.

Le premier noyau magnétique et/ou, lorsqu'il est présent, le second noyau magnétique sont avantageusement réalisé en matériau ferromagnétique.

Le premier noyau magnétique et/ou, lorsqu'il est présent, le second noyau magnétique sont avantageusement réalisés en matériau nanocristallin.

L'évidement central du premier noyau magnétique est avantageusement rempli d'un matériau ferromagnétique.

Le dispositif peut comprendre plusieurs premiers noyaux magnétiques toriques formés autour d'un évidement central, et plusieurs premiers conducteurs électriques formés chacun de spires enroulées autour d'un des premiers noyaux magnétiques sans traverser l'évidement central du premier noyau magnétique autour duquel le premier conducteur électrique considéré est enroulé. Les premiers noyaux magnétiques sont disposés à l'intérieur de l'évidement central du deuxième noyau magnétique.

Le dispositif selon la revendication peut comprendre en outre un troisième noyau magnétique torique disposé à l'intérieur du deuxième évidement central, les premiers noyaux magnétiques étant disposés entre le deuxième noyau magnétique et le troisième noyau magnétique.

Le premier noyau magnétique peut être réalisé sous forme d'un empilement de plusieurs noyaux magnétiques élémentaires autour desquels le premier conducteur électrique est enroulé.

L'invention sera mieux comprise et d'autres avantages apparaîtront à la lecture de la description détaillée d'un mode de réalisation donné à titre d'exemple, description illustrée par le dessin joint dans lequel :
les figures 1 et 2 représentent deux modes de réalisation de bobines enroulées autour d'un noyau magnétique torique et conforme à l'invention ;
les figures 3 et 4 représentent deux variantes du mode de réalisation de la figure 2 ;
les figures 5a, 5b, 6a et 6b représentent respectivement l'utilisation des bobines des figures 1 et 2 dans des dispositifs de filtrage plus complexes ;
la figure 7 représente un exemple d'utilisation d'un des dispositifs de filtrage des figures 3 ou 4 ;
la figure 8 représente une variante du dispositif de la figure 3 ;
la figure 9 représente une autre variante d'un dispositif selon l'invention ;
les figures 10 à 16 représentent plusieurs variantes d'empilage de noyaux magnétiques pouvant être mises en oeuvre pour réaliser des dispositifs de filtrage conformes à l'invention.

Par souci de clarté, les mêmes éléments porteront les mêmes repères dans les différentes figures.

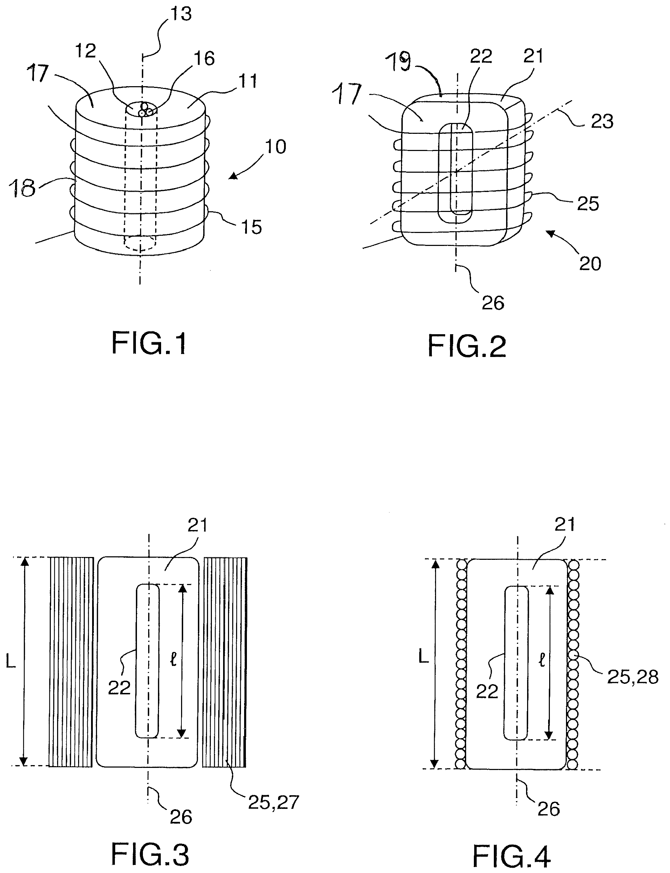

La figure 1 représente un premier mode de réalisation d'un dispositif de filtrage 10 comprenant un noyau magnétique 11 torique sans entrefer formé autour d'un évidement central 12. Le noyau magnétique 11 est de forme cylindrique et s'étend autour d'un axe 13. L'évidement central 12 s'étend également selon l'axe 13.

Le dispositif de filtrage 10 comprend un conducteur électrique 15 formé de spires enroulées autour du noyau magnétique 11. Le conducteur électrique 15 peut posséder une section plate par exemple sous forme d'un feuillard ou d'une tresse que l'on enroule autour du noyau magnétique 11 en empilant les spires les unes au dessus des autres. Alternativement, le conducteur électrique 15 peut posséder une section circulaire. Les spires peuvent être disposées cote à cote sur une ou plusieurs couches. Le conducteur électrique 15 peut être réalisé dans différents alliages métalliques, tels que des alliages de cuivre ou d'aluminium.

La présence d'un évidement central 12 permet de faciliter la réalisation du noyau magnétique, notamment lorsqu'il est réalisé en matériau nanocristallin du fait de la fabrication de ce matériau en ruban enroulé autour de l'évidement central 12. De façon conventionnelle, en présence d'un évidement central 12, les spires d'un dispositif de filtrage sont formées en traversant l'évidement central 12. Cela permet de fermer le circuit magnétique. Au contraire, et de façon non conventionnelle, l'invention propose d'enrouler les spires du conducteur électrique 15 autour du noyau magnétique 11 sans traverser l'évidement central 12. Pris isolément, le dispositif de filtrage 10 comprend un circuit magnétique ouvert, ce qui, a priori, est moins performant qu'un circuit magnétique fermé. En revanche, cela permet de bobiner les spires du conducteur électrique 15 de façon beaucoup plus simple sans traverser un évidement central. Dans la variante de la figure 1, l'enroulement des spires du conducteur électrique 15 se fait autour de l'axe 13.

L'invention est bien adaptée à un noyau magnétique 11 réalisé en matériau ferromagnétique nanocristallin. Il est également possible de réaliser le noyau magnétique 11 dans d'autres types de matériaux ferromagnétiques. Il est possible de remplir l'évidement central 12 d'un matériau ferromagnétique afin de profiter du volume libre laissé dans l'évidement central pour augmenter encore la valeur de self du conducteur électrique 15. Le matériau de remplissage peut être d'un type différent de celui utilisé pour le noyau magnétique 11. Sur la figure 1, le remplissage de l'évidement central 12 est réalisé au moyens de billes 16 en matériau ferromagnétique. D'autres formes peuvent être employées pour remplir l'évidement central 12.

La figure 2 représente un deuxième mode de réalisation de dispositif de filtrage 20 comprenant un noyau magnétique 21 torique sans entrefer formé autour d'un évidement central 22. Le noyau magnétique 21 est également de forme cylindrique s'étendant autour d'un axe 23. L'évidement central 22 s'étend selon l'axe 23. La notion de forme cylindrique doit être comprise au sens large, c'est-à-dire une forme développée à partir d'une courbe quelconque et d'une génératrice s'appuyant sur la courbe. Pour obtenir l'évidement central 22, la courbe est fermée. La présence d'une courbe fermée facilite la réalisation du noyau magnétique à partir de rubans enroulés en suivant la forme de la courbe fermée. Dans l'exemple de la figure 2, la courbe est sensiblement rectangulaire et la génératrice de la forme cylindrique est une direction portée par l'axe 23. Toute autre forme de courbe est bien entendu possible dans le cadre de l'invention.

Le dispositif de filtrage 20 comprend un conducteur électrique 25 formé de spires enroulées autour du noyau magnétique 21. Contrairement au dispositif de filtrage 10 où le conducteur 15 est enroulé autour de l'axe 13 selon lequel s'étend l'évidement central 12, le conducteur électrique 25 est enroulé autour du noyau magnétique 21 selon un axe 26 sensiblement perpendiculaire à l'axe 23. Dans l'exemple représenté, où la courbe fermée est sensiblement rectangulaire, l'axe 26 est parallèle à la plus grande longueur du rectangle. Alternativement, il est possible d'enrouler les spires du conducteur 25 autour d'un axe parallèle à la plus petite longueur du rectangle. Cependant, un axe d'enroulement des spires parallèle à la plus grande longueur du rectangle permet, pour un même nombre de spires, de les enrouler plus près du circuit magnétique et ainsi augmenter la valeur de self du dispositif de filtrage 20.

Comme pour le dispositif 10, il est possible de remplir l'évidement central 22 d'un matériau ferromagnétique.

Comme pour le mode de réalisation de la figure 1, le noyau magnétique 21 peut être réalisé en matériau ferromagnétique nanocristallin ou dans d'autres types de matériaux ferromagnétiques. Les noyaux magnétiques 11 et 21 peuvent être réalisés sans entrefer, ce qui est bien adapté au matériau ferromagnétique nanocristallin, ou au moyen de noyaux coupés et assemblés ce qui est adapté à d'autres types de matériaux ferromagnétiques. Le choix peut être fait en fonction de la disponibilité sur le marché de noyaux magnétiques coupés ou non coupés.

Les dispositifs de filtrage 10 et 20 représentés sur les figures 1 et 2 comprennent chacun un seul enroulement formé respectivement par les conducteurs 15 et 25. Alternativement, toujours dans le cadre de l'invention, plusieurs enroulements peuvent être formés autour d'un même noyau magnétique afin de coupler ces enroulements.

Des essais en interne ont montré que le dispositif de filtrage 10 permet d'obtenir une plus grande valeur d'inductance que le dispositif de filtrage 20. Une explication possible de ce résultat est qu'à l'intérieur de la bobine du dispositif de filtrage 10, les lignes de champ magnétique suivent le matériau du noyau magnétique 11 de façon continue. Les lignes de champ sont sensiblement rectilignes à l'intérieur du noyau magnétique 11. En revanche, dans le dispositif de filtrage 20, certaines de ces lignes de champ sont discontinues en traversant l'évidement central ou possèdent des directions non rectilignes dans le noyau magnétique 21. En d'autres termes, les lignes de champ magnétiques sont mieux canalisées dans le noyau magnétique 11 que dans le noyau magnétique 21 d'où la possibilité d'obtenir une plus grande valeur d'inductance pour le dispositif de filtrage 10.

Le dispositif de filtrage 20 présente cependant un avantage en termes de dissipation thermique notamment lorsque le noyau magnétique est réalisé en matériau nanocristallin du fait de sa fabrication en ruban enroulé autour de l'axe 23 de l'évidement central. Effet les faces du noyau magnétique perpendiculaire à cet axe d'enroulement ont un état de surface bien moins plan que les autres faces. Plus précisément, le noyau magnétique 11 comprend deux faces planes 17 perpendiculaires à l'axe 13 et une face cylindrique 18 s'étendant autour de l'axe 13. Lors de la fabrication du noyau magnétique 11, la face cylindrique 18 présente une surface lisse tandis que les faces planes 17 sont striées du fait de l'empilement des couches de ruban. Afin d'évacuer la chaleur générée dans le dispositif de filtrage 10 due aux pertes magnétiques, il n'est possible de placer un radiateur que sur une des faces planes 17 (ou éventuellement sur les deux faces planes 17) car la face 18 est occupée par le conducteur électrique 15. L'état de surface des faces planes 17 entraine un contact incertain entre le radiateur et la face plane 17 considérée, ce qui n'est pas favorable aux échanges thermiques entre les faces planes 17 et le radiateur.

Dans le dispositif de filtrage 20, le noyau magnétique 21 présente deux faces striées portant également le repère 17 et deux faces planes 19 non masquées par le conducteur 25. Les faces planes 19 ne sont pas perpendiculaires à l'axe 23 autour duquel le ruban en matériau nanocristallin est enroulé. Les faces planes 19 présentent donc un état de surface comparable à celui de la surface cylindrique 18, c'est-à-dire lisse, ce qui est propice à un meilleur contact avec un radiateur.

La figure 3 représente en coupe une variante du dispositif 20 dans lequel le conducteur 25 est réalisé au moyen d'un feuillard 27 enroulé autour du noyau magnétique 21. La plus grande longueur, notée l de la section cylindrique de l'évidement central 22 s'étend selon l'axe 26. Le fait d'enrouler le feuillard 27 autour du noyau magnétique 21 sans traverser l'évidement central 22 permet de choisir un feuillard 27 dont la largeur notée L est plus grande que la longueur l de l'évidement central 22. Cela permet d'utiliser au mieux la longueur extérieure du noyau magnétique 21 selon l'axe 26. Dans l'exemple représenté, la largeur du feuillard 27 est égale à la longueur extérieure du noyau magnétique 21. La valeur de self obtenue par l'enroulement du feuillard 27 s'en trouve augmentée.

La figure 4 représente en coupe une autre variante du dispositif 20 dans lequel le conducteur 25 est réalisé au moyen d'un conducteur électrique 25 à section circulaire et repéré 28. La longueur de la bobine réalisée en enroulant le conducteur 28 est définie selon l'axe 26. Dans l'exemple représenté, la longueur de la bobine est égale à la longueur extérieure du noyau magnétique 21. La longueur de la bobine est donc également repérée L sur la figure 4 et est également plus grande que la longueur I de l'évidement central 22. La valeur de self obtenue par l'enroulement du conducteur 28 s'en trouve également augmentée. Sur la figure 4, le conducteur 28 forme une seule couche de spires. La bobine ainsi formée peut bien entendu comprendre plusieurs couches de spires.

De façon plus générale, une dimension caractéristique L de la bobine réalisée en enroulant le conducteur électrique 25 est supérieure à la plus grande dimension l de la section cylindrique de l'évidement central 22, les deux dimensions étant portées par la même direction, en l'occurrence l'axe 26. Cette caractéristique est également vérifiée pour le mode de réalisation représenté sur la figure 1. De préférence, la dimension caractéristique L de la bobine est sensiblement égale à la plus grande dimension extérieure du noyau magnétique toujours mesurée selon l'axe 26 afin que le flux magnétique présent à l'intérieur de la bobine soit guidé au maximum par le noyau magnétique.

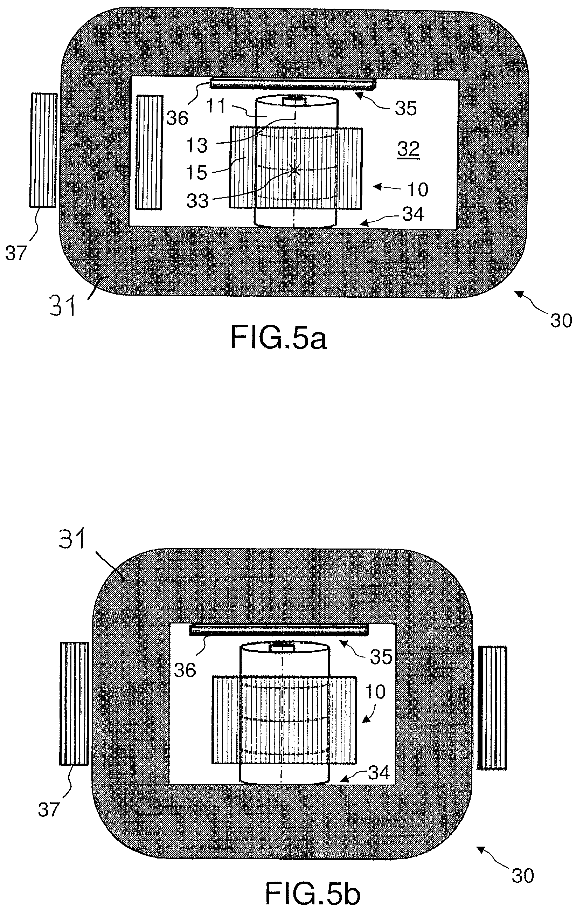

Les figures 5a et 5b représentent l'utilisation du dispositif 10 de la figure 1 dans un dispositif de filtrage 30 plus complexe. Le dispositif de filtrage 30 comprend un noyau magnétique 31 torique sans entrefer formé autour d'un évidement central 32. Le premier dispositif 10 est disposé à l'intérieur de l'évidement central 32 de sorte que le noyau magnétique 31 referme un circuit magnétique formé par le noyau magnétique 11.

Le noyau magnétique 31 peut être réalisé en matériau ferromagnétique et notamment matériau ferromagnétique nanocristallin afin d'y concentrer les lignes de champ magnétiques formées dans le noyau magnétique 11 lors du passage d'un courant dans le conducteur 15.

Le noyau magnétique 31 est également de forme cylindrique s'étendant autour d'un axe 33 perpendiculaire au plan de la figure 3. La forme cylindrique s'appuie sur une courbe fermée sensiblement rectangulaire. L'axe 13 autour duquel les spires du conducteur électrique 15 sont enroulées est sensiblement perpendiculaire à l'axe 33.

Le noyau magnétique 11 peut être en contact avec le noyau magnétique 31 au niveau de deux cotés opposés de la courbe sensiblement rectangulaire. Des entrefers 34 et 35 se forment au niveau de chacun des contacts entre les deux noyaux magnétiques 11 et 31. Il est possible de disposer dans l'un des entrefers ou éventuellement dans les deux, une cale 36 pouvant être magnétique ou amagnétique. Une cale 36 magnétique permet de combler le jeu fonctionnel entre les deux noyaux magnétiques 11 et 31 en canalisant au mieux le flux magnétique générée par les spires du conducteur 25. Au contraire, une cale 36 amagnétique permet de laisser subsister un entrefer non magnétique et ainsi de contrôler la valeur du courant de saturation et de limiter la variation de la valeur de la self. Pus précisément, tant que le noyau magnétique 11 n'est pas saturé, la valeur de self reste constante. Si l'intensité du courant circulant dans le conducteur électrique 15 augmente de façon à saturer le noyau magnétique 11, la valeur de self décroit. Le fait d'interposer une cale 36 amagnétique permet d'augmenter l'intensité du courant au delà de laquelle la saturation est atteinte.

Il est possible de compléter le dispositif 30 avec un autre conducteur électrique 37 formé de spires enroulées autour du noyau magnétique 31. Sur la figure 5a, l'enroulement des spires du conducteur électrique 37 peut, cette fois, être réalisé de façon conventionnelle en traversant l'évidement central 32 du noyau magnétique 31. Ici encore un ou plusieurs enroulements peuvent être formés autour du noyau magnétique 31. Alternativement, ou en complément, comme représenté sur la figure 5b, le conducteur électrique 37 peut être enroulé autour du noyau magnétique 31 de façon non conventionnelle, c'est-à-dire sans traverser l'évidement central 32.

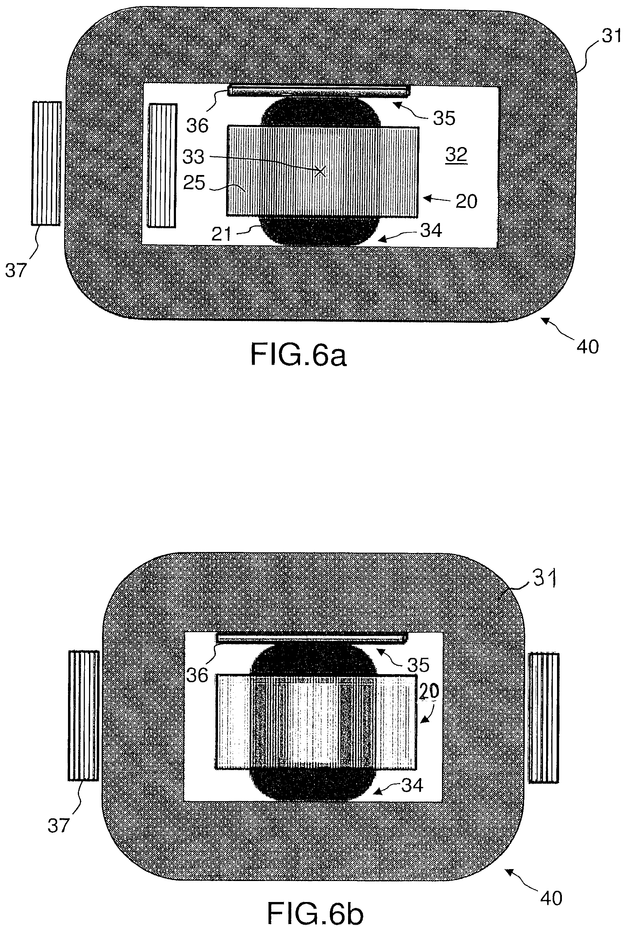

Les figures 6a et 6b représentent l'utilisation du dispositif 20 de la figure 2 dans un dispositif de filtrage 40 semblable au dispositif de filtrage 30. On retrouve dans le dispositif de filtrage 40 le noyau magnétique 31 et éventuellement le conducteur électrique 37 enroulé de façon conventionnelle, comme représenté sur la figure 6a. Comme précédemment, alternativement ou en complément, comme représenté sur la figure 6b le conducteur électrique 37 peut être enroulé autour du noyau magnétique 31 de façon non conventionnelle. L'axe 26 autour duquel les spires du conducteur électrique 25 sont enroulées est sensiblement perpendiculaire à l'axe 33. Une ou plusieurs cales 36 peuvent être disposées dans l'un ou dans les entrefers 34 et 35.

Comme pour les noyaux magnétiques 11 et 21, le noyau magnétique 31 peut être réalisé sans entrefer, c'est-à-dire non coupé. Alternativement, on peut réaliser le noyau magnétique 31 à partir de noyaux coupés, ce qui est avantageux dans le cas où le conducteur électrique 37 est enroulé de façon conventionnelle. L'assemblage du noyau magnétique 31 est alors réalisé après insertion de la bobine du conducteur 27 sur les parties coupées.

Dans les dispositifs représentés sur les figures 5b et 6b, aucun conducteur électrique ne traverse l'évidement central 32. Le fait d'enrouler le conducteur électrique 37 de façon non conventionnelle permet d'augmenter sa dimension caractéristique, comme décrit à l'aide des figures 3 et 4.

Avec ou sans conducteur électrique 37, le noyau magnétique 31 présent dans les dispositifs de filtrage 30 et 40 forme un radiateur permettant d'évacuer la chaleur générée par les pertes magnétiques des dispositifs 10 et 20. Comme indiqué plus haut, l'échange thermique entre le dispositif 20 et le noyau magnétique 31 dans les variantes des figures 6a et 6b se fait mieux que l'échange thermique dans le dispositif de filtrage 30 des figures 5a et 5b entre le dispositif 10 et le noyau magnétique 31.

Par contre, la valeur d'inductance du dispositif de filtrage est plus élevée dans les variantes des figures 5a et 5b que dans les variantes des figures 6a et 6b.

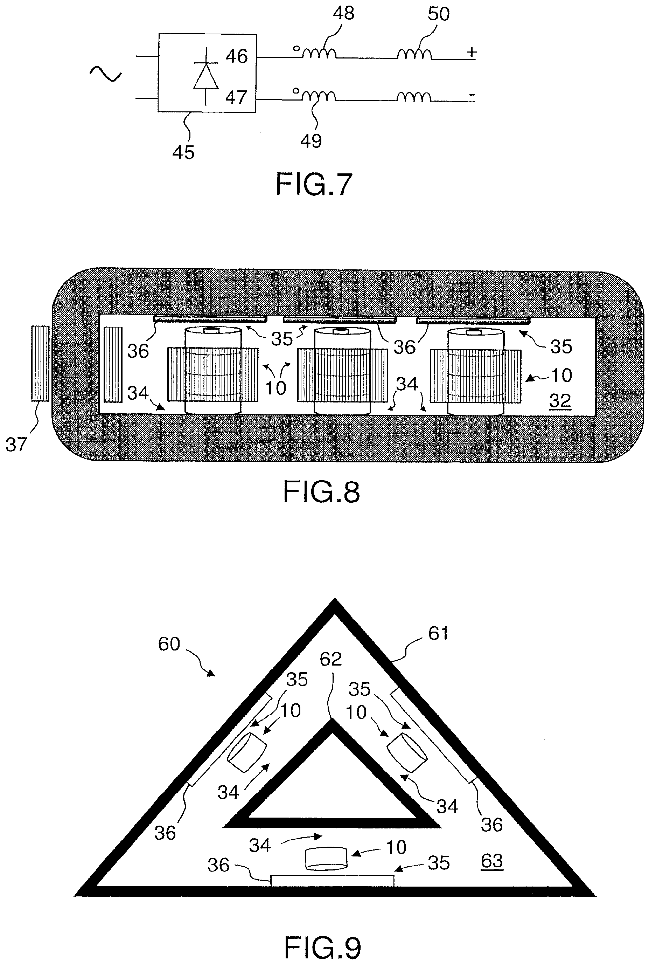

La figure 7 représente un exemple d'utilisation d'un des dispositifs de filtrage 10 ou 20. Ces dispositifs peuvent être mis en oeuvre pour un filtrage de mode commun et différentiel en sortie d'un convertisseur 45 délivrant une tension continue entre deux sorties 46 et 47. Le filtrage de mode commun peut être réalisé au moyen de deux enroulements 48 et 49 connectés chacun en série avec l'une des deux sorties 46 et 47. Les deux enroulements 48 et 49 sont enroulés dans le même sens, par exemple de façon conventionnelle, et/ou de façon non conventionnelle, autour du noyau magnétique 31 comme le conducteur électrique 37. Le filtrage différentiel peut être réalisé au moyen d'un enroulement 50 connecté en série sur l'une des sorties par exemple la sortie 46. L'enroulement 50 peut être formé par le conducteur électrique 15 enroulé autour du noyau magnétique 11. D'autres composants, tels que des condensateurs, peuvent compléter l'exemple de filtrage décrit à l'aide de la figure 7. De nombreux autres types de connexions d'enroulements sont bien entendu possibles pour assurer un filtrage en sortie d'un convertisseur.

La figure 8 représente une variante du dispositif de la figure 3 comprenant plusieurs dispositifs 10 disposés à l'intérieur de l'évidement central 32 du noyau magnétique 31 pour former un dispositif de filtrage 55. Les différents dispositifs 10 sont tous disposés entre deux faces opposées de l'évidement central 32. Une cale 36 peut être disposée entre chacun des circuits magnétiques 11 et le circuit magnétique 31. Plusieurs dispositifs 20 ou d'autres dispositifs analogues peuvent être mis en oeuvre à la place des différents dispositifs 10. Le dispositif de filtrage 55 peut également comprendre un conducteur 37 enroulé autour du noyau magnétique 31 et/ou de façon non conventionnelle.

La figure 9 représente une autre variante d'un dispositif de filtrage 60 conforme à l'invention et comprenant plusieurs dispositifs 10, trois dans l'exemple représenté. Le noyau magnétique 31 est ici remplacé par deux noyaux magnétiques 61 et 62 toriques sans entrefer formés chacun autour d'un évidement central, respectivement, 63 et 64. Les deux noyaux magnétiques 61 et 62 sont imbriqués. Plus précisément, l'évidement central 63 du noyau magnétique 61 est configuré pour contenir le noyau magnétique 62. Les dispositifs 10 sont disposés à l'intérieur de l'évidement central 63 entre les deux noyaux magnétiques 61 et 62. Dans l'exemple représenté, les deux noyaux magnétiques 61 et 62 ont tous deux une forme cylindrique développée à partir d'une courbe triangulaire représentée dans le plan de la figure 9 et d'une génératrice perpendiculaire au plan de la figure 9. Les courbes triangulaires sont équilatérales et les cotés des triangles de chacun des noyaux magnétiques 61 et 62 se font face. Un dispositif 10 est disposé entre les faces parallèles de chacun des deux triangles. La fermeture de chacun des circuits magnétiques 11 des dispositifs 10 est en partie réalisée par le noyau magnétique 61 et en partie par le noyau magnétique 62. Comme précédemment, Les noyaux magnétiques 61 et 62 peuvent être réalisés en matériau ferromagnétique et notamment matériau ferromagnétique nanocristallin. Une cale 36 peut être disposée entre chacun des circuits magnétiques 11 et l'un des circuits magnétiques 61 et 62. Comme précédemment, des dispositifs de filtrage 20 peuvent remplacer les dispositifs de filtrage 10.

Il est bien entendu possible de disposer plus d'un dispositif 10 entre deux faces parallèles de chacun des triangles. Une disposition en triangle est par exemple adaptée au filtrage d'un réseau triphasé. D'autres formes de noyaux magnétiques sont également envisageables dans le cadre de l'invention. Des enroulements semblables à l'enroulement 37 peuvent être disposés autour d'un ou des deux noyaux magnétiques 61 et 62 de façon conventionnelle ou non conventionnelle.

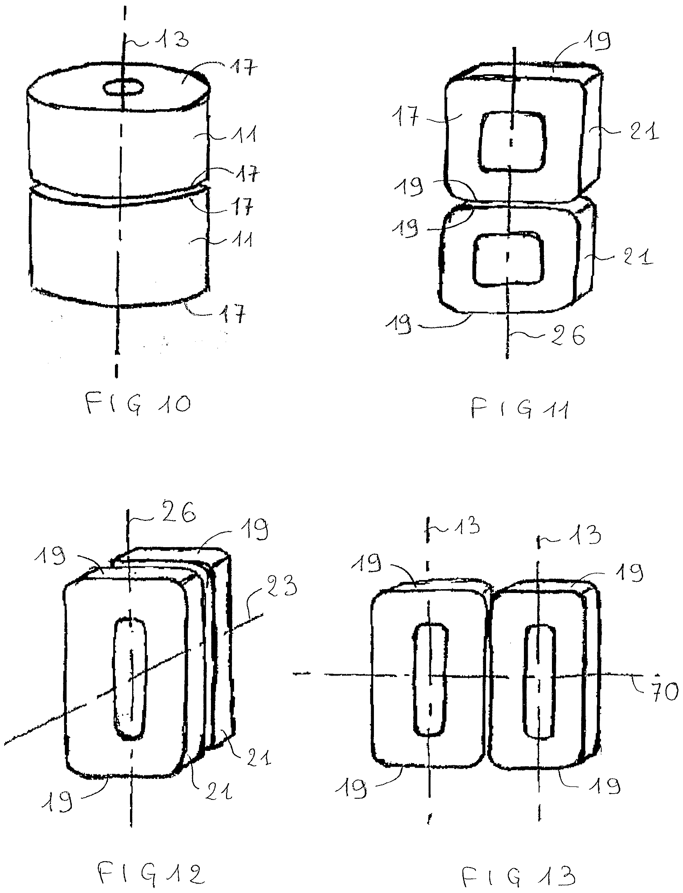

Les figures 1 à 4 représentent des modes de réalisation de bobine enroulées autour d'un circuit magnétique unique. Dans le cadre de l'invention, il est possible d'empiler plusieurs noyaux magnétiques 11 ou 21 et de former un même enroulement autour de cet empilage. Les figures 10 à 13 représentent plusieurs variantes d'empilage de noyaux magnétiques autour desquels un ou plusieurs conducteurs électriques sont enroulés pour réaliser des dispositifs de filtrage élémentaires ayant des fonctions similaires à ceux décrits sur les figures 1 à 4. Autour des empilages des figures 10 à 13, il est possible d'enrouler toute forme de conducteur électrique, comme par exemple des conducteurs électriques longilignes, par exemple à section ronde ou carrée. Il est également possible d'enrouler des feuillards tels que décrits à l'aide de la figure 3.

La figure 10 représente deux noyaux magnétiques 11 empilés selon leur axe 13. La figure 11 représente deux noyaux magnétiques 21 empilés selon leur axe 26. La figure 12 représente deux noyaux magnétiques 21 empilés selon leur axe 23. La figure 13 représente deux noyaux magnétiques 21 empilés selon un axe 70 perpendiculaire aux axes 23 et 26. Les figures 10 à 13 représentent des empilements de deux noyaux magnétiques élémentaires. Il est bien entendu possible d'empiler plus de deux noyaux magnétiques. Il est même possible d'empiler des noyaux magnétiques élémentaires suivant plusieurs axes distincts, par exemple à la fois selon plusieurs axes parmi les axes 23, 26 et 70.

Comme évoqué plus haut, dans l'empilage de la figure 10, les deux noyaux magnétiques sont en contact par leur face 17 qui, dans le cas d'une réalisation en matériau nanocristallin enroulé, ne présentent pas un bon état de surface. Par contre dans l'empilage de la figure 11, les noyaux magnétiques 21 sont en contact par leur face 19, ce qui est favorable à un bon échange thermique. Dans les empilages des figures 12 et 13, les faces 19 des deux noyaux magnétiques 21 restent libres pour un contact avec un radiateur si l'enroulement du conducteur électrique se fait autour de l'axe 13.

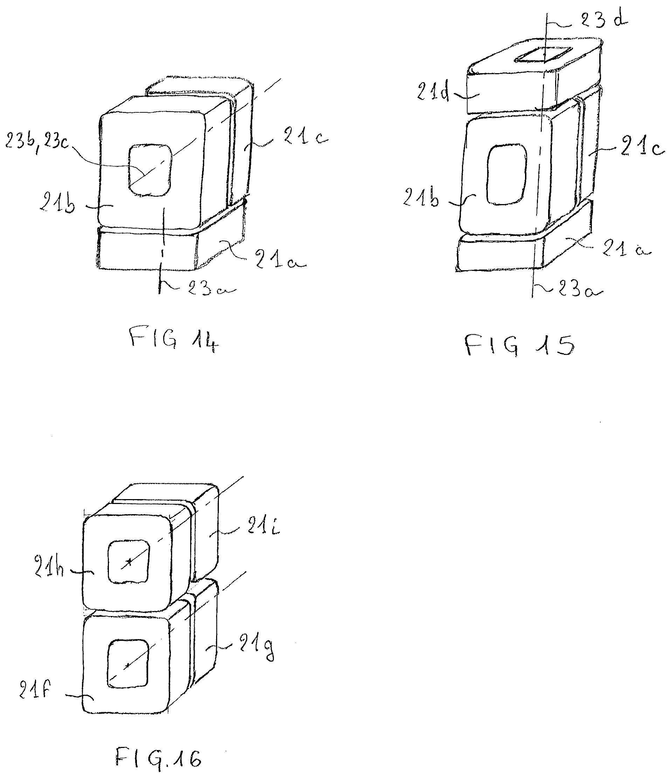

Dans les figures 10 à 13, les axes des différents noyaux empilés sont tous confondus ou parallèles entre eux. Alternativement, comme représenté sur les figures 14 et 15, les axes des différents noyaux peuvent être perpendiculaires entre eux.

Sur la figure 14 trois noyaux 21 sont empilés. Pour les distinguer, ils porteront les repères 21a, 21b et 21c. L'axe 23a du noyau 21a est vertical et les axes 23b et 23c des noyaux, respectivement 21b et 21c sont horizontaux et confondus. Les deux noyaux 21b et 21c sont placés au-dessus du noyau 21a et masquent son évidement central.

Sur la figure 15, on retrouve les trois noyaux 21a, 21b et 21c ainsi qu'un quatrième noyau 21d dont l'axe 23d est confondu avec l'axe 23a du premier noyau 21a. Le noyau 21d est disposé au-dessus des deux noyaux 21b et 21c.

Sur la figure 16, quatre noyaux 21f, 21g, 21h et 21i sont empilés. Les axes de ces quatre noyaux sont parallèles.

Les exemples donnés sur les figures 14, 15 et 16 ne sont pas limitatifs. Tout autre empilage de noyaux quel que soit l'orientation de leur axe est bien entendu possible. L'intérêt de ce type d'empilage réside principalement dans l'adaptation des performances électromagnétiques au volume disponible. En effet, on a vu plus haut que le dispositif de filtrage 10 permet d'obtenir une plus grande valeur d'inductance que le dispositif de filtrage 20. En conséquence lorsque dans un même volume il est possible d'empiler préférentiellement des noyaux de telle sorte à obtenir une majorité de noyaux dont l'axe est parallèle à l'axe d'enroulement des spires, on pourra obtenir une plus grande valeur d'inductance que lorsque dans le même volume, une majorité de noyaux possèdent des axes perpendiculaires à l'axe d'enroulement des spires.

Par exemple, en supposant que les empilages des figures 15 et 16 occupent le même volume, et que l'enroulement des spires se fasse autour d'un axe vertical, un dispositif de filtrage réalisé avec l'empilage de la figure 15 possède une plus grande valeur d'inductance qu'un dispositif de filtrage réalisé avec l'empilage de la figure 16.

Cette adaptation peut se faire à partir de noyaux magnétiques standards. A partir de mêmes noyaux élémentaires, il est possible de faire varier la valeur d'inductance en modifiant l'orientation des noyaux dans l'empilage. Pour ce faire, on choisit par exemple des noyaux à section carrée perpendiculairement à leur axe et dont l'épaisseur selon leur axe est égale à la moitié du côté du carré de la section. Autrement dit un noyau élémentaire occupe sensiblement le volume d'un demi cube. Ceci permet d'obtenir le même volume pour les empilages des figures 15 et 16.

Avant de réaliser le bobinage de l'enroulement autour de l'empilage, il est possible de prévoir un maintien mécanique permettant de solidariser les différents noyaux de l'empilage. Il est notamment possible de prévoir un cerclage entourant l'empilage. Alternativement il est possible de noyer l'empilage dans une résine.

## Revendications

1. Dispositif de filtrage comprenant :
• un premier noyau magnétique (21) torique sans entrefer de forme cylindrique s'enroulant autour d'un axe du premier noyau (23) et formé autour d'un évidement central (22), s'étendant également selon l'axe du premier noyau (23),
• un premier conducteur électrique (25) formé de spires enroulées autour du premier noyau magnétique (21) sans traverser l'évidement central (22), le premier conducteur électrique (25) est enroulé autour du premier noyau magnétique (21) selon un axe d'enroulement (26) sensiblement perpendiculaire à l'axe du premier noyau (23),
dans lequel aucun conducteur électrique ne traverse l'évidement central (22).

2. Dispositif selon la revendication 1, dans lequel une dimension caractéristique (L) d'une bobine réalisée en enroulant le premier conducteur électrique (25) est supérieure à une plus grande dimension (l) d'une section cylindrique de l'évidement central (22), la dimension caractéristique (L) et la plus grande dimension (l) de la section cylindrique étant portées par une même direction (26).

3. Dispositif selon la revendication 2, dans lequel la dimension caractéristique (L) de la bobine est sensiblement égale à une plus grande dimension extérieure (L) du noyau magnétique (11, 21) portée par la direction (26).

4. Dispositif selon l'une des revendications précédentes, comprenant en outre un deuxième noyau magnétique (31, 61) torique formé autour d'un deuxième évidement central (32, 62), le premier noyau magnétique (11, 21) étant disposé à l'intérieur du deuxième évidement central (32, 62), de sorte que le deuxième noyau magnétique (31, 61) torique referme un circuit magnétique formé par le premier noyau magnétique (21).

5. Dispositif selon la revendication 4, dans lequel un entrefer (34, 35) est présent entre le premier noyau magnétique (21) et le deuxième noyau magnétique (31, 61), le dispositif comprenant en outre au moins une cale (36) magnétique ou amagnétique disposée dans l'entrefer (34, 35).

6. Dispositif selon l'une quelconque des revendications 4 ou 5, comprenant en outre un deuxième conducteur électrique (37) formé de spires enroulées autour du deuxième noyau magnétique (31, 61).

7. Dispositif selon la revendication 6, dans lequel aucun conducteur électrique ne traverse le deuxième évidement central (32, 62), les spires du deuxième conducteur électrique (37) étant enroulées autour du deuxième noyau magnétique (31, 61) sans traverser le deuxième évidement central (32, 62).

8. Dispositif selon l'une quelconque des revendications 4 à 7, dans lequel le deuxième noyau magnétique (31) torique s'enroule autour d'un deuxième axe d'enroulement (33) et dans lequel le premier et le deuxième axes d'enroulement sont sensiblement parallèles.

9. Dispositif selon l'une des revendications précédentes, dans lequel le premier noyau magnétique (21) et/ou, lorsqu'il est présent, le second noyau magnétique (31) sont réalisés en matériau ferromagnétique.

10. Dispositif selon l'une des revendications précédentes, dans lequel le premier noyau magnétique (21) et/ou, lorsqu'il est présent, le second noyau magnétique sont réalisés en matériau nanocristallin.

11. Dispositif selon l'une des revendications précédentes, dans lequel l'évidement central (22) du premier noyau magnétique (21) est rempli d'un matériau ferromagnétique (16).

12. Dispositif selon l'une quelconque des revendications 4 à 11 en tant que revendication dépendante de la revendication 4, comprenant plusieurs premiers noyaux magnétiques (21) toriques formés autour d'un évidement central (22), et plusieurs premiers conducteurs électriques (25) formés chacun de spires enroulées autour d'un des premiers noyaux magnétiques (21) sans traverser l'évidement central (22) du premier noyau magnétique (21) autour duquel le premier conducteur électrique (25) considéré est enroulé, dans lequel les premiers noyaux magnétiques (21) sont disposés à l'intérieur de l'évidement central (32, 62) du deuxième noyau magnétique (31, 61).

13. Dispositif selon la revendication 12, comprenant en outre un troisième noyau magnétique (62) torique disposé à l'intérieur du deuxième évidement central (63), les premiers noyaux magnétiques (20) étant disposés entre le deuxième noyau magnétique (61) et le troisième noyau magnétique (62).

14. Dispositif selon l'une des revendications précédentes, dans lequel le premier noyau magnétique est réalisé sous forme d'un empilement de plusieurs noyaux magnétiques élémentaires autour desquels le premier conducteur électrique (25) est enroulé.
